# EUROPEAN PATENT APPLICATION

(11) **EP 1 727 204 A2**
(43) Date of publication of application: **29.11.2006**
(21) Application number: 06114481.2
(22) Date of filing: 24.05.2006
(51) Int. Cl.: H01L 27/115, H01L 21/8247

(54) **Method for embedding NROM**

(30) Priority: 25.05.2005 US 137042
(71) Applicant: Saifun Semiconductors Ltd., Netanya 42505 (IL)
(72) Inventor: Bloom, Ilan, 34790, Haifa (IL)
(74) Representative: Andersson, Björn E.

(57) **Abstract**

A method for embedding non-volatile memories with logic circuitry, without changing performance of both the logic circuitry and the NVM elements (and/or without changing a sequence of manufacturing steps for both the logic circuitry and the NVM elements). The embedding process includes insertion of NVM device and anay process steps into an existing logic CMOS process in a way that maintains the CMOS performance, thereby enabling use of existing circuit libraries. The NVM may thus be combined with the high-speed low-voltage CMOS without any performance or reliability penalty.

## Description

### FIELD OF THE INVENTION

The present invention relates generally to methods for embedding non-volatile memories with logic circuitry, such as but not limited to, high speed, low voltage CMOS.

### BACKGROUND OF THE INVENTION

It is possible to combine memories with logic, this being referred to in the literature as "embedded memories", A type of memory of particular importance in embedded applications is the non-volatile memory (NVM), such as but not limited to, EPROM (Electrically Programmable Read Only Memory) and EEPROM (Electrically Erasable Programmable Read only Memory), Flash and single or multi-level NVM cells or combinations. The memory element is formed by a transistor with a floating gate whose threshold voltage is determined by the written information in the form of electric change on the floating gate electrode. The control gate on the one hand serves to detect what the threshold voltage (the written information) is during reading and on the other hand to influence the potential of the floating gate during writing and/or erasing. Such memories may be embedded with CMOS (complementary metal oxide semiconductor) logic circuitry.

Manufacturing embedded memories poses many challenges because the normal processing techniques for non-volatile memories are not readily integrated with the normal processing techniques for logic circuitry Embedding NVM capabilities into high speed MOS entails incorporating manufacturing steps for the NVM devices as well as steps for high voltage CMOS elements typically needed for the operation of the NVM memory elements

However, the manufacturing steps for forming the NVM and high voltage components are not readily combined together with the steps for forming the logic elements. This forces the manufacturer to diamatically alter the processes normally used to form the logic elements The manufacturer thus cannot use the normal workflow and assembly line to make embedded memories into the standard low-voltage logic CMOS.

The extra manufacturing steps needed to incorporate NVM and HV CMOS may affect the high speed CMOS performance. Typically incorporation efforts lead to a compromise in performance of both NVM and fast CMOS devices, forcing the manufacturer to modify the design libraries available for the fast logic CMOS that were no longer valid due to the degradation of the fast CMOS transistor parameters.

### SUMMARY OF THE INVENTION

The present invention seeks to provide methods for embedding non-volatile memories and HV CMOS circuitry into an existing logic low-voltage CMOS process, as is described more in detail herein below, without changing performance of both the logic circuitry and the NVM elements and without changing a sequence of manufacturing steps for both the logic circuitry and the NVM elements. The embedding process includes insertion of the NVM process steps into an existing logic CMOS process in a way that maintains the CMOS performance, enabling to use existing circuit libraries, The CMOS devices parameters are not degiaded due to such a combination of elements, and there is no penalty in performance or reliability.

The invention is applicable, for example, for forming one bit, dual-bit or multi-bit Nitride Read Only Memory (NROM) cells embedded with logic circuitry in one chip. In one embodiment of the invention, the NROM elements are formed with shallow trench isolation, as is described more in detail hereinbelow.

In accordance with an embodiment of the present invention, a process is provided that incorporates (embeds) the NVM MROM device and HV CMOS devices into the high-speed logic CMOS. Some of the manufacturing steps may serve for more than one device type, whereas other steps may be dedicated to a specific device. In one embodiment, in the overall sequence of steps, there are no changes in the NVM, HV and logic low voltage CMOS sequences The high thermal drive manufacturing steps of NVM and HV CMOS are integrated early in the general flow to avoid influence on the LV high speed CMOS devices.

There is thus provided in accordance with an embodiment of the present invention a method for embedding NROM process steps into high-speed logic CMOS process steps, the method including forming isolation areas for logic CMOS and for NROM and high voltage CMOS elements, forming high thermal drive elements of the NROM and the high voltage (HV) CMOS elements, and forming low thermal drive elements for the logic CMOS and for the NROM and the high voltage CMOS elements

In accordance with an embodiment of the present invention forming the high thermal drive process elements of the NROM and the high voltage CMOS elements includes forming at least one ONO layer and at least one HV gate oxide, the high thermal drive elements of the NROM and the high voltage CMOS elements being formed before the low and mid thermal drive elements.

Further in accordance with an embodiment of the present invention forming the mid thermal drive elements of the logic CMOS includes forming at least one gate oxide layer of the logic CMOS. The low thermal drive elements of the NROM and HV CMOS may include a variety of implants and anneal steps

There is also provided in accordance with an embodiment of the present invention a method for embedding non-volatile memories with logic circuitry, the method including providing a first set of manufacturing steps for forming high speed, low voltage CMOS (complementary metal oxide semiconductor) logic circuitry on a circuitry substrate not embedded with non-volatile memory (NVM) elements, and combining a second set of manufacturing steps for forming NVM elements on the circuitry substrate together with the first set of manufacturing steps so as to form a circuitry substrate including the logic circuitry embedded with the NVM elements, without changing performance of the logic circuitry, the NVM elements and HV devices.

The second set of manufacturing steps for forming the NVM elements may include steps for forming NROM elements. The second set of manufacturing steps for forming NVM elements on the circuitry substrate may be combined together with the first set of manufacturing steps without changing a sequence of manufacturing steps for both the logic circuitry and the NVM elements. The first set of manufacturing steps may include masks for forming the high speed, low voltage CMOS logic circuitry and the second set of manufacturing steps may include no more than two, four or six additional masks for forming the NVM elements and/or high voltage circuitry elements. A plurality of common masks may be used for forming both the logic circuitry and the NVM elements.

In accordance with an embodiment of the present invention the second set of manufacturing steps includes steps for simultaneously forming NVM elements of more than one different NVM architectures, such as but not limited to, EPROM (electrically programmable read only memory), EEPROM (electrically erasable programmable read only memory), OTP (one time programming), flash, code flash, data flash, serial flash, ROM (read only memory) replacement, and single or multi-level NVM cells.

### BRIEF DESCRIPTION OF THE DRAWINGS

The present invention will be understood and appreciated more fully from the following detailed description taken in conjunction with the appended drawings in which:
Fig. 1 is a generalized method for combining non-volatile memory devices and HV CMOS devices with existing high speed LVCMOS process, in accordance with an embodiment of the present invention;
Fig. 2 is a more specific, non-limiting example of a process chart for embedding non-volatile memories with logic circuitry, in accordance with an embodiment of the present invention; and
Fig. 3 describes a non-limiting example of a mask sequence for embedded process flow, integrating the existing LV and mid voltage (MV) devices with HV CMOS devices and NROM devices, in accordance with an embodiment of the present invention.

### DETAILED DESCRIPTION OF THE PRESENT INVENTION

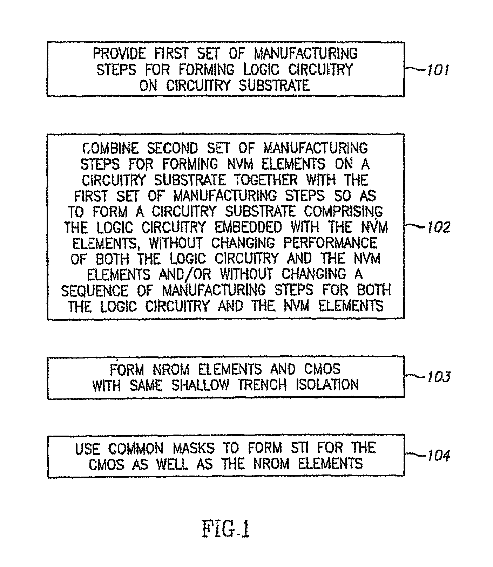

Reference is now made to Fig. 1, which illustrates a method for embedding non-volatile memories with logic circuitry, in accordance with an embodiment of the present invention.

A first set of manufacturing steps may be given and defined for forming logic circuitry on a circuitry substrate (step 101). The first set of manufacturing steps may be a standard set of processes with masks for forming different circuit features, such as but not limited to, p-wells, n-wells, junctions, contacts, vias, metal lines, poly lines and the like. The first set of manufacturing steps may be standard manufacturing steps for manufacturing high speed, low voltage CMOS logic, for example. The first set of manufacturing steps is independent from the manufacturing steps used to make non-volatile memory elements. In other words, the first set of manufacturing steps may be used to manufacture logic circuitry without any connection to embedding non-volatile memory elements. This is in contrast with the prior art which must use some special set of logic manufacturing steps, which is a modification of the normal manufacturing steps used to make logic, in order to embed memory with the logic circuitry.

In accordance with an embodiment of the present invention, a second set of manufacturing steps is provided for forming NVM elements and HV CMOS on a circuitry substrate. This second set of manufacturing steps is combined together with the first set of manufacturing steps so as to form a circuitry substrate comprising the logic circuitry embedded with the NVM elements and HV CMOS, without changing performance of both the logic circuitry and the NVM elements, and/or without changing each sequence of manufacturing steps for forming the logic circuitry and NVM elements (step 102).

The process of embedding includes merging the individual process flows of existing high speed logic CMOS, HV CMOS devices and NVM elements, so that in the combined embedded flow, each subset sequence for each of the three elements (high speed logic CMOS, HV CMOS devices and NVM elements) is not changed. The merging may include placing some high thermal drive process steps early in the combined flow, such as (but not restricted to) ONO formation and/or HV GOX (gate oxide) formation. Mid thermal drive process steps may be placed later in the flow. Finally, sensitive steps that are not to be exposed to high thermal drive are placed as late as possible in the combined flow.

"Without changing performance of both the logic circuitry and the NVM elements" means that both the logic circuitry and the NVM elements perform as if they were manufactured with the same manufacturing steps on separate circuitry substrates. "Without changing the sequence of manufacturing steps" means that none of the manufacturing steps is altered individually or collectively, and the order of the steps remains the same.

In accordance with an embodiment of the present invention, the NVM elements formed with the second set of manufacturing steps may be nitride, read only memory (NROM) elements. The NROM elements and the CMOS may be formed with the same trenches of the shallow trench isolation (STI) (step 103). This may be advantageous due to the fact that a common mask may be used to form STI for the logic as well as the NROM elements (step 104). Trenches provided for the STI may be etched by means of a mask, and the trenches may be subsequently filled with oxides, for example. Other masks or process steps may also be combined if possible, in order to save steps.

Using STI to form NROM elements is a known technique. For example, US Patent 6,794,249 to Willer et al. describes a non-volatile memory cell with an ONO (oxide-nitride-oxide) layer, which may be used in a virtual-ground architecture, wherein the active region of the cell is isolated by STI. US Patent 6,794,249, the disclosure of which is incorporated herein by reference, may be used to make NROM cells, for example, or any kind of cell constructed with SONOS (semiconductor-oxide-nitride-oxide-semiconductor). Such cells (e.g., NROM and SONOS) may be programmed by channel-hot electrons and may be erased using hot holes.

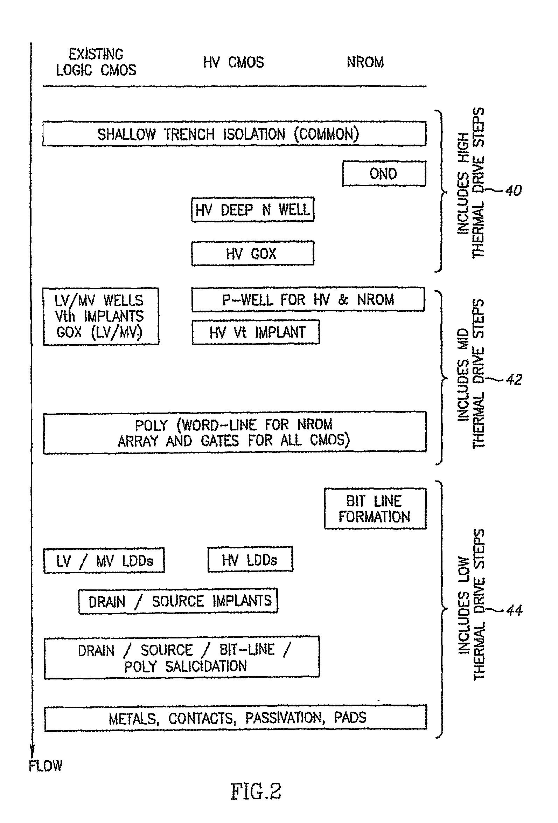

Reference is now made to Fig. 2, which is a more specific, non-limiting example of a process chart for embedding non-volatile memories with logic circuitry, in accordance with an embodiment of the present invention. It is emphasized that the process steps are merely for exemplary purposes only, and the invention is not limited in any way to this example.

As mentioned above, high thermal drive process steps (indicated by reference numeral 40) may be placed early in the combined flow, such as but not limited to, ONO formation and/or HV GOX formation. Some presses which are not high thermal drive steps may be performed about the same time as the high thermal drive steps. For example, the common STI may be formed before the ONO and a high voltage deep n well may be formed before the HV GOX. Mid thermal drive process steps (indicated by reference numeral 42) may follow, including but not limited to low voltage/mid voltage GOX for the existing logic CMOS, high voltage threshold voltage dopant for the HV CMOS,. Finally, sensitive steps (referred to as low thermal drive steps, indicated by reference numeral 44) that should not be exposed to high thermal drive are placed as late as possible in the combined flow. Such steps may include without limitation, bit line formation for the NROM, low voltage/mid voltage LDDs (lightly doped drains) for the existing logic CMOS, HV LDDs for the HV CMOS, drain and source implants and drain/source/bit-line/polysalicidation for the existing logic CMOS and the HV CMOS. Metallization, contacts, passivation and pads may be formed for all three elements.

It is noted that the order of forming some of the high thermal drive and mid thermal drive steps may be modified in accordance with different embodiments of the invention. For example, the HV p-well or cell-well or both may be implemented (formed) before/during/after ONO formation, or before/during/after MV GOX formation, or before/during/after LV GOX formation. Some implants may be implemented (formed) before one of the GOX steps. A bit-line implant may be implemented (formed) after poly implants.

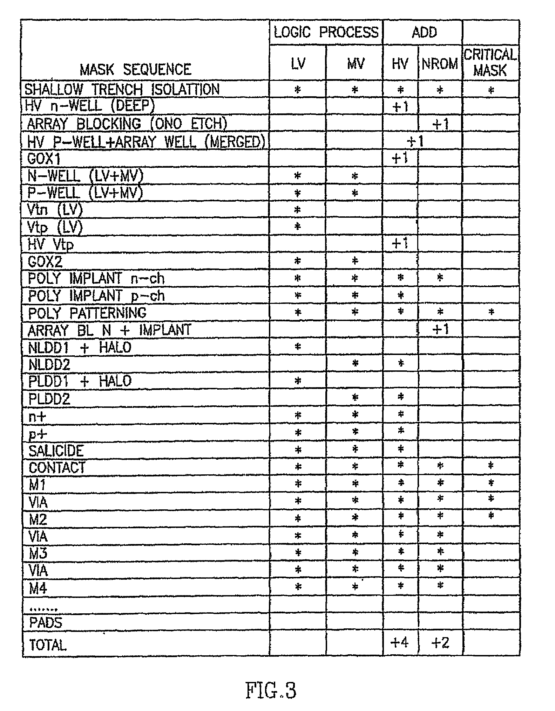

Reference is now made to Fig. 3, which is a more specific, non-limiting example of a mask sequence for embedded process flow, integrating the existing LV and mid voltage devices with HV CMOS devices and NROM devices, in accordance with an embodiment of the present invention. It is emphasized that these steps are merely for exemplary purposes only, and the invention is not limited in any way to this example.

In the illustrated non-limiting example, not only the shallow isolation trenches for the LV and MV logic, high voltage elements and the NROM may by etched with a single common mask. In other words, in the first step, isolation is formed for all devices - logic CMOS, high voltage elements and the NROM.

Afterwards, a high voltage deep n-well may be formed. An array blocking ONO region may then be formed to etch out the ONO in the CMOS circuitry region. A high voltage deep p-well may be formed along with an array well, merged into one well.

Afterwards, a first, high voltage gate oxide layer may be formed, followed by a low voltage/mid voltage n-well and a low voltage/mid voltage p-well. A threshold voltage n-dopant (Vtn) and a threshold voltage p-dopam (Vtp) may then be introduced (both low voltage), followed by a HV Vt implant A second gate oxide may be formed followed by poly deposition and patterning and array bit line and other implants. One or more lightly- or moderately-doped source/drain extension implants NLDD (n lightly doped drain) and PLDD (p lightly doped drain) may then be formed. Afterwards, various n+ and p+ dopants, contacts, metallized layers, vias and pads may be formed. For example, a salicide process may be implemented, which is a self-aligned silicide process, meaning that silicide contacts are formed only in those areas in which deposited metal is in direct contact with the silicon and polysilicon. The dopants may involve a masked implantation of boron, phosphorus and other species and subsequent annealing of the dopings, for example, as is known in the art.

It is seen from the example illustrated in Fig. 3, that it is possible to form the NROM elements by adding no more than two additional masks, and to form the relatively high voltage circuitry elements by adding no more than four additional masks. It is contemplated that even with more complicated circuitry, it is possible to form the NROM elements by adding no more than four additional masks, and to form the high voltage circuitry elements with the NROM elements by adding a total of no more than six additional masks, It is further contemplated that with certain relatively simple circuitry, it is possible to form the NROM dements by adding just one additional mask and to form the relatively high voltage circuitry elements by adding just one additional mask.

The present invention enables forming the circuitry substrate with logic circuitry embedded with NVM elements having a process minimum feature size of 6F² per bit, although the invention is not limited to this value. This is a significant improvement over the prior art, which typically needs 15F² per bit for embedded NVM elements,

It is noted that for the sake of simplicity and clarity, detailed steps involved with the masking and etching have not been specified (e.g., applying and removing protect layers, thermal oxidation, cleaning, etc.) Such processes are well known to those skilled in the art and do not require further description for the skilled artisan.

In summary, in accordance with a non-limiting embodiment of the invention, the invention may be used to incorporate more than one NVM architecture in the same process flow, such as but not limited to, EPROM (electrically programmable read only memory), EEPROM (electrically erasable programmable read only memory), OTP (one time programming), flash, code flash, data flash, serial flash, ROM (read only memory) replacement, and single or multiple NVM cells.

It will be appreciated by persons skilled in the art that the present invention is not limited by what has been particularly shown and described herein above. Rather the scope of the invention is defined by the claims that follow:

## Claims

1. A method for embedding NROM (Nitride Read Only Memory) process steps and HV CMOS devices into high-speed logic CMOS (complementary metal oxide semiconductor) process steps, the method including:
forming isolation areas for logic CMOS and for NROM and high voltage CMOS elements;
forming high thermal drive process elements of said NROM and said high voltage (HV) CMOS elements; and
forming mid thermal drive process elements of said logic CMOS elements; and
forming low thermal drive process elements for said logic CMOS and for said NROM and said high voltage CMOS elements.

2. The method according to claim 1, wherein forming the high thermal drive elements of said NROM and said high voltage CMOS elements comprises forming at least one ONO layer and at least one HV gate oxide, the high thermal drive elements of said NROM and said high voltage CMOS elements being formed before said low and mid thermal drive process elements.

3. The method according to claim 1 or 2 wherein forming the mid thermal drive process elements of the logic CMOS comprises forming at least one gate oxide layer of the logic CMOS, the mid thermal drive process elements being formed before said low thermal drive process elements and after the high thermal drive elements.

4. The method according to claim 1, 2, or 3, wherein forming the low thermal drive process elements of the NROM and HV CMOS comprises forming at least one bit-line implant, at least one high voltage Vt implant, at least one HV LDD (lightly doped drain), and at least one drain/source implant.

5. The method according to any of claims 1-4, wherein the isolation areas are formed with shallow trench isolation (STI).

6. A method for embedding non-volatile memories with logic circuitry, the method comprising:
providing a first set of manufacturing steps for forming high speed, low voltage CMOS (complementary metal oxide semiconductor) logic circuitry on a circuitry substrate not embedded with non-volatile memory (NVM) elements; and
combining a second set of manufacturing steps for forming NVM elements on the circuitry substrate together with said first set of manufacturing steps so as to form a circuitry substrate comprising said logic circuitry embedded with said NVM elements, without changing performance of both said logic circuitry and said NVM elements.

7. The method according to claim 6. wherein the second set of manufacturing steps for forming the NVM elements comprises steps for forming nitride, read only memory (NROM) elements,

8. The method according to claim 6 or 7, comprising combining the second set of manufacturing steps for forming NVM elements on the circuitry substrate together with said first set of manufacture steps without changing, a sequence of manufacturing steps for both said logic circuitry and said NVM elements

9. The method according to claim 7, comprising forming the NROM elements with shallow trench isolation (STI).

10. The method according to any of claims 6-9. wherein the first set of manufacturing steps comprises masks for forming the high speed, low voltage CMOS logic circuitry and the second set of manufacturing steps comprises no more than four additional masks for forming the NVM elements

11. The method according to any of claims 6-9, wherein the first set of manufacturing steps comprises masks for forming the logic circuitry and the second set of manufacturing steps comprises no more than two additional masks for forming the NVM elements.

12. The method according to any of claims 6-11. wherein the second set of manufacturing steps comprises additional masks for forming high voltage circuitry elements.

13. The method according to any of claims 6-12, wherein the second set of manufacturing steps comprises a total of six additional masks for forming the NVM elements and the high voltage circuitry elements

14. The method according to any of claims 6-12, wherein the second set of manufacturing steps comprises no more than four additional masks for forming the high voltage circuitry elements.

15. The method according to any of claims 6-14, wherein the first and second sets of manufacturing steps comprise a plurality of common masks for forming both the logic circuitry, the NVM elements and HV CMOS elements.

16. The method according to any of claims 6-15, wherein the second set of manufacturing steps comprises steps for simultaneously forming NVM elements of two different NVM architectures.

17. The method according to claim 16, wherein the two different NVM architectures comprise at least two of the following architectures: EPROM (electrically programmable read only memory), EEPROM (electrically erasable programmable read only memory), OTP (one time programming), flash, code flash, data flash, serial flash, ROM (read only memory) replacement, and single NVM cells.

18. The method according to any of claims 6-17, wherein the second set of manufacturing steps comprises steps for forming the circuitry substrate with said logic circuitry embedded with said NVM elements having a process minimum feature size of less than 8F² per bit.

19. A method for embedding NROM process steps and HV CMOS devices into high-specd logic CMOS process steps, comprising:
forming shallow isolation trenches for high-speed logic CMOS, HV CMOS and NROM early in the flow, performing a group of steps comprising forming HV n-well, forming ONO, forming HV GOX, forming HV p-well and cell-well, forming MV and LV GOX, and forming poly formations, then afterwards performing sensitive steps that are not to be exposed to high thermal drive steps.

20. The method according to claim 19, wherein in the group of steps, at least one of the HV n-well, HV p-well and cell-well are formed before ONO formation

21. The method according to claim 19 or 20, wherein in the group of steps, at least one of the HV n-well. HV p-well and cell-well are formed after ONO formation.

22. The method according to claim 19, 20, or 21, wherein in the group of steps, at least one of the HV n-well, HV p-well and cell-well are formed during ONO formation.

23. The method according to any of claims 19-22, wherein in the group of steps, some implants are formed before one of the GOX steps.

24. The method according to any of claims 19-23, wherein in the group of steps, a bit-line implant is formed after poly formations.

25. The method according to any of claims 19-24, wherein in the group of steps, at least one of the HV n-well, HV p-well and cell-well are formed before MV GOX formation.

26. The method according to any of claims 19-25, wherein in the group of steps, at least one of the HV n-well, HV p-well and cell-well are formed after MV GOX formation.

27. The method according to any of claims 19-26, wherein in the group of steps, at least one of the HV n-well, HV p-well and cell-well are formed during MV GOX formation

28. The method according to any of claims 19-27, wherein in the group of steps, at least one of the HV n-well, HV p-well and cell-well are formed before LV GOX formation.

29. The method according to any of claims 19-28, wherein in the group of steps, at least one of the HV n-well, HV p-well and cell-well are formed after LV GOX formation.

30. The method according to any of claims 19-29, wherein in the group of steps, at least one of the HV n-well, HV p-well and cell-well are formed during LV GOX formation.
